(19) Europäisches Patentamt
European Patent Office
Office européen des brevets

(11) Veröffentlichungsnummer: **0 513 402 A1**

(12) **EUROPÄISCHE PATENTANMELDUNG**

(21) Anmeldenummer: **91106653.8**

(51) Int. Cl.5: **H03F 1/32**, H03H 21/00

(22) Anmeldetag: **24.04.91**

(43) Veröffentlichungstag der Anmeldung:
**19.11.92 Patentblatt 92/47**

(84) Benannte Vertragsstaaten:
**AT BE CH DE DK ES FR GB GR IT LI LU NL SE**

(71) Anmelder: **ASEA BROWN BOVERI AG**

**CH-5401 Baden(CH)**

(72) Erfinder: **Puri, Narindra Nath, Prof.Dr.**
**5, Drinking Brook Rd,. Monmouth Jct.**
**New Jersey, NY 08852(US)**

(54) **Verfahren zur Kompensation von Nichtlinearitäten einer Verstärkerschaltung mit ausgeprägter Signaldurchlaufszeit.**

(57) Die Erfindung betrifft ein Verfahren zur Kompensation von Nichtlinearitäten einer Verstärkerschaltung (1) mit ausgeprägter Signaldurchlaufszeit. Ein Eingangssignal s(t) wird unter Verwendung einer vorgegebenen, mit Nichtlinearitäten behafteten Verstärkerschaltung (1) zu einem Ausgangssignal y(t) verstärkt. Zum Ausgleichen der Nichtlinearitäten ist ein Vorverzerrungsfilter (4) vorgesehen, das das Eingangssignal s(t) unter Verwendung des tatsächlichen Ausgangssignals y(t) und der Koeffizienten $k_1$, ..., $k_L$ sowie der Durchlaufszeit $t_d$ der Verstärkerschaltung (1) im Sinn einer Feedback-Steuerung zum Eingangssignal x(t) vorverzerrt. Das vorverzerrte Eingangssignal x(t) wird der mit Nichtlinearitäten behafteten Verstärkerschaltung (1) zugeführt. Die vorgegebene Zahl L von Koeffizienten $k_1$, ..., $k_L$ sowie die Durchlaufszeit $t_d$ der Verstärkerschaltung (1) werden entsprechend dem Modell

$$u(t) = \sum_{\mu=1}^{L} k_\mu x^\mu(t-t_d)$$

bestimmt werden, so dass bei einem gegebenen Eingangssignal x(t) der Verstärkerschaltung (1) das gemäss dem Modell ermittelte Ausgangssignal u(t) mit dem tatsächlichen Ausgangssignal y(t) der Verstärkerschaltung (1) im wesentlichen übereinstimmt,

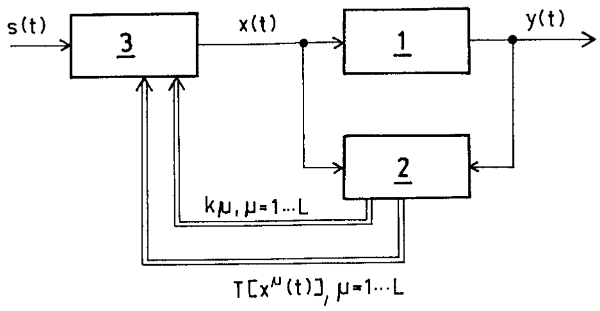


FIG.1

EP 0 513 402 A1

## Technisches Gebiet

Die Erfindung betrifft ein Verfahren zur Kompensation von Nichtlinearitäten einer Verstärkerschaltung mit ausgeprägter Signaldurchlaufszeit, bei welchem ein Eingangssignal s(t) unter Verwendung einer vorgegebenen, mit Nichtlinearitäten behafteten Verstärkerschaltung (z.B. Leistungsverstärker für Audiosignale) zu einem Ausgangssignal y(t) verstärkt wird,

## Stand der Technik

Verstärkerschaltungen, insbesondere Tonverstärker hoher Leistung, wie sie zur Modulation von Rundfunksendern im LW-, MW- und KW-Bereich eingesetzt werden, sind üblicherweise mit Nichtlinearitäten behaftet, die es zu eliminieren gilt. Die klassische Lösung zur Linearisierung der Charakteristik sieht eine Rückführung des Ausgangssignals vor (Feedback). Das Mass dieser Rückführung hängt von der Charakteristik des Verstärkers im nichtrückgekoppelten Zustand ab.

Aus der Regelungstechnik ist bekannt, wie bei linearen Verzerrungen einer Schaltung die Rückführung zu konzipieren ist, damit insgesamt eine lineare Charakteristik entsteht. Heutige nichtlineare Verstärkungsverfahren schliessen die lineare Rückführung oft aus regelungstechnischen Stabilitätsgründen aus. Die nicht vernachlässigbaren SignalDurchlaufszeiten können nämlich bei nicht durchdachter Rückführung das Verstärkungsverfahren instabil machen.

## Darstellung der Erfindung

Aufgabe der Erfindung ist es nun, ein Verfahren der eingangs genannten Art anzugeben, welches insbesondere für Audiosignale eine lineare Verstärkung unter Verwendung moderner Hochleistungsverstärker gewährleistet und frei von Instabilitäten ist.

Erfindungsgemäss besteht die Lösung darin, dass bei einem Verfahren der eingangs genannten Art

a) eine vorgegebene Zahl L von Koeffizienten $k_1$, ..., $k_L$ sowie eine Durchlaufszeit $t_d$ der Verstärkerschaltung entsprechend dem Modell

$$u(t) \equiv \hat{y}(t) = \sum_{\mu=1}^{L} k_\mu x^\mu(t-t_d)$$

bestimmt werden, so dass bei einem gegebenen Eingangssignal x(t) der Verstärkerschaltung das gemäss dem Modell ermittelte Ausgangssignal u(t) mit dem tatsächlichen Ausgangssignal y(t) der Verstärkerschaltung im wesentlichen übereinstimmt,

b) in einem Vorverzerrungsfilter das Eingangssignal s(t) unter Verwendung des tatsächlichen Ausgangssignals y(t) und der Koeffizienten $k_1$, ..., $k_L$ sowie der Durchlaufszeit $t_d$ der Verstärkerschaltung im Sinn einer Feedback-Steuerung zum Eingangssignal x(t) vorverzerrt wird, und

c) das vorverzerrte Eingangssignal x(t) der mit Nichtlinearitäten behafteten Verstärkerschaltung zugeführt wird.

Der Kern der Erfindung liegt darin, dass die Charakteristik der Verstärkerschaltung, welche eine ausgeprägte Signaldurchlaufszeit und eine nichtlineare Amplitudenverstärkung aufweist, entsprechend dem Modell

$$u(t) \equiv \hat{y}(t) = \sum_{\mu=1}^{L} k_\mu x^\mu(t-t_d)$$

identifiziert wird und dass in einem vorgeschalteten Vorverzerrungsfilter das Eingangssignal s(t) gemäss diesem Modell (d.h. den Koeffizienten $k_1$, $k_2$,..., $k_L$ und der bestimmten Durchlaufszeit $t_d$) so vorverzerrt wird, dass am Ausgang der Verstärkerschaltung ein gewünschtes linear verstärktes Ausgangssignal $y^*(t) = k_1$ s-(t-$t_d$) vorliegt. Es wird also ein Kompensationssignal so erzeugt, dass insgesammt die unerwünschten Signalkomponenten ($k_2$, $k_3$,..., $k_L$) eliminiert werden.

In der früheren Europäischen Anmeldung 90113326.4 (Anmeldetag 12.7.90) wurde ein Lösungsansatz gewählt, der zwar auch der Signallaufzeit Rechnung trägt, allerdings nur in beschränktem Umfang (nämlich

nur für sehr kleine Verzögerungen). Dadurch, dass es nun gelungen ist, die Signalverzögerung einerseits unabhängig von ihrer Grösse zu bestimmen und andererseits voll in die Vorverzerrung miteinzubeziehen, ist es möglich geworden, auch schwingungsfreie Vorverzerrung nach dem Prinzip des Feedbacks zu verwirklichen.

Die Vorverzerrung nach dem Feedback-Prinzip läuft im einzelnen vorzugsweise wie folgt ab:

a) das Eingangssignal s(t) (d.h. das zu verstärkende Audiosignal) wird entsprechend der zuvor bestimmten Durchlaufszeit $t_d$ verzögert;

b) das verzögerte Eingangssignal $s(t-t_d)$ wird mit dem entsprechend dem Modell ermittelten, aktuellen linearen Koeffizienten $k_1(i)$ multipliziert,um $y^*(t)$ zu bilden;

c) aus dem verzögerten und multiplizierten Eingangssignal s(t) und dem Ausgangssignal y(t) der Verstärkerschaltung wird ein Differenzsignal e(t) gebildet:

$$e(t) = y(t) - y^*(t)$$

$$e(t) = \sum_{\mu=1}^{L} k_\mu(i)[s(t-t_d(i)) - c(t-t_d(i))]^\mu$$

d) das Differenzsignal wird mit einem Teilsignal $\partial e/\partial c$ der Form

$$\partial e/\partial c = \sum_{\mu=1}^{L} \mu k_\mu(i)[s(t - t_d(i))]^{\mu-1} ,$$

das aus dem geeignet verzögerten Eingangssignal s(t) gebildet wird, multipliziert;

e) ein stabiles Kompensationssignal c(t) wird gemäss

$$c(t) = -K_c \{ \int [e(t)\cdot\partial e/\partial c]dt + t_d(i)e(t)\cdot\partial e/\partial c \}$$

gebildet; und

f) als vorverzerrtes Eingangssignal x(t) der Verstärkerschaltung wird das Summensignal aus Kompensationssignal c(t) und Eingangssignal s(t) verwendet:

$$x(t) = s(t) + c(t) .$$

Eine Alternative zur Feedback-Steuerung stellt die Feedforward-Steuerung dar, die keine geschlossene Schleife beinhaltet (open loop). Sie basiert auf dem selben Verstärkermodell wie die Feedback-Lösung, verwendet aber die ermittelten Koeffizienten auf andere Weise. Im Unterschied zur oben erwähnten Lösung wird in einem Vorverzerrungsfilter im Sinn einer offenen Feedforward-Steuerung allein unter Verwendung des gegebenen Eingangssignal x(t) der Verstärkerschaltung sowie der Koeffizienten $k_1$, ..., $k_L$ und der Durchlaufszeit $t_d$ der Verstärkerschaltung ein zum Einganssignal s(t) additives Kompensationssignal c(t) gebildet wird. Dieses Kompensationssignal c(t) wird zum Eingangssignal s(t) hinzuaddiert (Vorverzerrung). Schliesslich wird das resultierende Summensignal als Eingangssignal x(t) der mit Nichtlinearitäten behafteten Verstärkerschaltung zugeführt.

Gemäss einer bevorzugten Ausführungsform wird bei der Feedforward-Lösung das Kompensationssignal zunächst im Fourierraum konstruiert und dann mittels einer schnellen Fouriertransformation (FFT) in den Zeitbereich gebracht.

Die Fourierkoeffizienten $C_n(i)$ des additiven Kompensationssignals c(t) werden gemäss der Beziehung

$$C_n(i) = K \sum_{\mu=2}^{L} k_\mu(i)\ T[x^\mu(t)] \ , \ n = -N...N+1 \ ,$$

ermittelt. Der Koeffizient K kann wahlweise nach einer einfachen oder einer komplizierten Relation ermittelt werden. Im einfachen Fall gilt

$K = -1/k_1(i)$.

Die präzisere, wenn auch um einiges aufwendigere Variante lautet:

$K = -K_c k_1(i)\alpha^n(i)\,[jn\pi T_s/N + K_c k_1{}^2(i)\alpha^n(i)]^{-1}$

$K_c$ ist eine beliebig vorgebbare Konstante, die auf das Steuerungsprinzip keinen Einfluss hat. Wenn sie allerdings geeignet gewählt wird, dann kann die Konvergenz des Kompensationsverfahrens verbessert werden.

Die Identifikation der Koeffizienten und der Durchlaufszeit wird vorzugsweise wie folgt durchgeführt:

a) Das Eingangssignal x(t) und das Ausgangssignal y(t) der Verstärkerschaltung werden mit einer Abtastrate $1/T_s$ abgetastet und einer schnellen Fouriertransformation unterworfen;

b) Bei einer zuvor bestimmten Durchlaufszeit $t_d(i-1)$ wird eine vorgegebene Zahl L von Koeffizienten $k_1$, ..., $k_L$ der Verstärkerschaltung entsprechend dem Modell

$$u(t) \equiv \hat{y}(t) = \sum_{\mu=1}^{L} k_\mu x^\mu(t-t_d)$$

geschätzt, indem mit den 2N Gleichungen der Form

$$Y_n(i) = \alpha^n(i-1) \sum_{\mu=1}^{L} k_\mu(i)\ T[x^\mu(t)]\ ,\ n = -N...N+1\ ,$$

die zu einem Steuerungsintervall (i) der Länge $2NT_s$ gehören, die Koeffizienten $k_\mu(i)$, $\mu = 1...L$, gemäss der Methode der kleinsten Fehlerquadrate bestimmt werden, so dass bei einem gegebenen Eingangssignal x(t) der Verstärkerschaltung das gemäss dem Modell ermittelte Ausgangssignal u(t) mit dem tatsächlichen Ausgangssignal y(t) der Verstärkerschaltung im wesentlichen übereinstimmt.

$Y_n(i)$ bezeichnet den Fourierkoeffizient des Ausgangssignals y(t) und T[•] den FFT-Operator mit Frequenzbegrenzung bei $N2\pi/T_s$. Die komplexe Grösse $\alpha(i-1)$ hängt mit der Durchlaufszeit wie folgt zusammen:

$\alpha(i-1) = \exp(-j2\pi(t_d(i-1) - t_{d0})/T_s)$

Dabei stellt $t_{d0}$ eine erste grobe Näherung für Durchlaufszeit $t_d(i-1)$ dar. Zu Beginn kann $t_d(i-1)$ ohne weiteres gleich $t_{d0}$ resp. $\alpha(i-1) = 1$ gesetzt werden. Im Idealfall stellt ja $t_{d0}$ ohnehin die tatsächliche (resp. die optimale Schätzung der) Durchlaufszeit dar.

Zur adaptiven Bestimmung der Durchlaufszeit $t_d(i)$ wird das überbestimmte Gleichungssystem (2N Gleichungen)

$$Y_n(i) = \alpha^n(i) \sum_{\mu=1}^{L} k_\mu(i)\ T[x^\mu(t)]\ ,\ n = -N...N-1\ ,$$

wobei

$t_d(i) = \arg\{\alpha(i)\}\ NT_s/\pi$

gilt, herangezogen. $\alpha(i)$ wird erfindungsgemäss unter Verwendung der ermittelten Koeffizienten $k_1(i)$, ..., $k_L(i)$ nach der Methode der kleinsten Fehlerquadrate bestimmt. Wenn $\alpha(i)$ aus dem überbestimmten Gleichungssystem ermittelt worden ist, dann ist auch die Durchlaufszeit $t_d(i-1)$ definiert (bis auf ganzzahlige Vielfache

von $T_s$).

Im Identifikationsprozessor wird das unmittelbare Eingangssignal x(t) der nichtlinearen Verstärkerschaltung entsprechend der ersten Näherung $t_{d0}$ der Durchlaufszeit gegenüber dem Ausgangssignal y(t) verzögert.

Im Sinn einer adaptiven Kompensation der Nichtlinearitäten werden in jedem Steuerintervall (i) der Länge $2NT_s$ die Koeffizienten $k_1(i)$, ..., $k_L(i)$ und die Durchlaufszeit $t_d(i)$ ständig neu bestimmt. Auf diese Weise kann auch der sich im Betrieb verändernden Charakteristik des Leistungsverstärkers ständig Rechnung getragen werden.

Eine für die Praxis der Sendertechnik gute Kompensation ergibt sich mit L = 3 Koeffizienten $k_1$, ..., $k_3$. Damit wird mit akzeptablem Rechenaufwand eine gute Linearität der Verstärkung erreicht.

Aus dem erfindungsgemässen Verfahren kann der Fachmann ohne weiteres eine geeignete Schaltandordnung ableiten. Die Erfindung umfasst somit auch eine Anordnung zum linearen Verstärken von Signalen, insbesondere für die Leistungsverstärkung von Audiosignalen, mit einer mit Nichtlinearitäten behafteten Verstärkerschaltung zum Erzeugen von Signalen hoher Leistung, welche Anordnung dadurch gekennzeichnet ist, dass

a) ein Identifikationsprozessor zum Bestimmen der Parameter der Verstärkerschaltung vorzugsweise gemäss der oben erwähnten Identifikation und

b) ein Vorverzerrungsfilter zum Erzeugen eines vorverzerrten Eingangssignal x(t) der Verstärkerschaltung aus einem Eingangssignal s(t) im Sinn der Erfindung vorgesehen sind.

Dem Anwender der erfindungsgemässen Schaltung steht also insgesamt ein Hochleistungsverstärker mit linearer Charakteristik zur Verfügung. Das vorzugsweise digitale Vorverzerrungsfilter lässt sich nämlich ohne weiteres im Gehäuse des fraglichen Leistungsverstärkers unterbringen.

Aus der Gesamtheit der abhängigen Patentansprüchen ergeben sich weitere vorteilhafte Ausführungsformen.

## Kurze Beschreibung der Zeichnungen

Nachfolgend soll die Erfindung anhand von Ausführungsbeispielen und im Zusammenhang mit den Zeichnungen näher erläutert werden. Es zeigen:

Fig. 1 ein Blockschaltbild einer Verstärkerbeschaltung nach dem Feedforward-Prinzip;
Fig. 2 ein Blockschaltbild eines Identifikationsprozessors zum Bestimmen der Koeffizienten $k_1$, ..., $k_L$;
Fig. 3 ein Blockschaltbild eines Vorverzerrungsfilters nach dem Feedforward-Prinzip;
Fig. 4 ein Blockschaltbild einer Verstärkerbeschaltung nach dem Feedback-Prinzip;
Fig. 5 ein Blockschaltbild eines Vorverzerrungsfilters nach dem Feedback-Prinzip; und
Fig. 6 ein Blockschaltbild eines Vorverzerrungsfilters nach dem Feedback-Prinzip unter Verwendung der schnellen Fouriertransformation..

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

## Wege zur Ausführung der Erfindung

Fig. 1 zeigt ein Schaltschema zur erfindungsgemässen Beschaltung einer Verstärkerschaltung 1. Ein Eingangssignal s(t), z.B. ein Audiosignal, soll mit dieser linear verstärkt werden zu einem Ausgangssignal y(t):

(I) $y(t) = k_1 s(t-t_d)$

Die vorgegebene Verstärkerschaltung 1, z.B. ein Hochleistungsverstärker, weist für sich eine nichtlineare Charakteristik und eine ausgeprägte SignalDurchlaufszeit $t_d$ auf. Dies hat zur Folge, dass Intermodulationen auftreten würden, wenn das Eingangssignal s(t) ohne irgendwelche Vorkehrungen direkt verstärkt würde.

Gemäss der Erfindung wird deshalb das Eingangssignal s(t) zunächst einem Vorverzerrungsfilter 3 zugeführt, welches eine geeignete Vorverzerrung durchführt. Das vorverzerrte Signal x(t) wird sodann von der Verstärkerschaltung 1 auf das geforderte Leistungsniveau gehoben. Die Parameter der Vorverzerrung werden mit einem Identifikationsprozessor 2 aus Ein- und Ausgangssignal x(t) resp. y(t) der Verstärkerschaltung 1 gewonnen.

Die Art und Weise der Vorverzerrung stellt ein wesentliches Merkmal der Erfindung dar. Sie soll im

folgenden unter Berücksichtigung des mathematischen Hintergrundes eingehend erläutert werden.

Das der Erfindung zu Grunde liegende mathematische Modell der Verstärkerschaltung 1 ist das folgende:

$$\text{(II)} \qquad u(t) \equiv \hat{y}(t) = \sum_{\mu=1}^{L} k_\mu x^\mu(t-t_d)$$

Neben dem gewünschten linearen Term $k_1 x(t-t_d)$ werden also auch quadratische, kubische etc Terme (d.h. $\mu > 1$) erzeugt. Durch die Verstärkung wird ferner eine Verzögerung gemäss der Durchlaufzeit $t_d$ eingebracht. Sowohl die L Koeffizienten $k_\mu$, $\mu = 1...L$, als auch die Durchlaufzeit sind unbekannt.

Gemäss der Erfindung sind diese Parameter nun so zu bestimmen, dass bei einem gegebenen, vorverzerrtem Eingangssignal x(t) der Verstärkerschaltung 1 das gemäss dem Modell ermittelte Ausgangssignal u(t) mit dem tatsächlichen Ausgangssignal y(t) der Verstärkerschaltung 1 im wesentlichen übereinstimmt. Allfällige Abweichungen sollten im optimalen Fall allein durch die Unzulänglichkeiten des Modells resp. durch die begrenzte Rechengenauigkeit bedingt sein.

Die Bestimmung der Koeffizienten $k_i$ übernimmt im vorliegenden Ausführungsbeispiel der Identifikationsprozessor 2. Er verwendet dazu das am Eingang der Verstärkerschaltung 1 direkt anliegende vorverzerrte Signal x(t) und das Ausgangssignal y(t). Die L Koeffizienten $k_\mu$, $\mu = 1...L$ und $t_d$, die er daraus berechnet, führt er an das Vorverzerrungsfilter 3 zurück. Schliesslich benötigt das Vorverzerrungsfilter 3 auch Informationen über das Eingangssignal x(t) der Verstärkerschaltung 1. Gemäss dem vorliegenden Beispiel werden dazu die bereits im Identifikationsprozessor gebildeten Grössen $T[x^\mu(t)]$, $\mu = 1...L$, herangezogen.

Der Einfachheit halber wird im folgenden die Zahl L der berücksichtigten Koeffizienten auf L = 3 festgelegt. Dies führt auch in der Praxis zu ziemlich guten Resultaten bei vernünftigem Rechenaufwand. Die Verallgemeinerung auf ein beliebiges anderes L stellt für den Fachmann keine besondere Schwierigkeit dar.

Das Prinzip der Identifikation geht aus Fig. 2 hervor. Sie beruht auf der Auswertung des Ein- und Ausgangssignals x(t) resp. y(t) der Verstärkerschaltung 1 und läuft im wesentlichen auf digitaler Ebene und im Fourierraum ab.

Das Eingangssignal x(t) wird zunächst mit einem Verzögerungsglied 20 um ein fest vorgegebenes Zeitintervall $t_{d0}$ verzögert. Die Verzögerung entspricht dabei in erster Näherung der tatsächlich in der Verstärkerschaltung auftretenden Durchlaufzeit $t_d$ des Signals.

Danach wird das verzögerte Eingangssignal $x(t-t_{d0})$ in einem A/D-Wandler 21 mit einer Rate $1/T_s$ abgetastet und digitalisiert. Ein FFT-Rechner 22 erzeugt die Fourierkoeffizienten $X_n(i)$ des abgetasteten Eingangssignals $x_m(i)$:

$$\text{(III)} \qquad X_n(i) = \frac{1}{2N} \sum_{m=-N}^{N-1} x_m(i) f_{mn} \quad , \; n = -N, \; ..., \; N-1$$

wobei

$$\text{(IV)} \qquad f_{mn} = \exp(-j\pi mn/N)$$

(Der in Klammern beigefügte Index "i" bezieht sich auf auf den aktuellen Steuerungszyklus.) Aus den Fourierkoeffizienten gemäss Gleichung (III) werden in einem Faltungsrechner 23 die Fourierkoeffizienten $A_n$-(i), $B_n(i)$ berechnet, die sich bei der Transformation von $x^2(t)$ und $x^3(t)$ ergeben:

$$\text{(V)} \qquad A_n(i) = T[x^2(t)] = \frac{1}{2N} \sum_{k=-N}^{N-1} X_k(i) X_{n-k}(i), \quad n = -N \ldots N-1$$

$$\text{(VI)} \qquad B_n(i) = T[x^3(t)] = \frac{1}{2N} \sum_{k=-N}^{N-1} A_k(i) X_{n-k}(i), \quad n = -N \ldots N-1$$

Mit T[•] wird ein Operator bezeichnet, der die schnelle Fouriertransformation durchführt, allerdings nur für Frequenzen des Grundsignals $X_n(i)$, d.h. nur für n = -N ... N-1.

Anstelle der Gleichungen (V) und (VI) können natürlich mit gleicher Wirkung die nachfolgenden Gleichungen (VII) und (VIII) ausgewertet werden, die davon ausgehen, dass zuerst die quadratischen und kubischen Signale $x^2(t)$ resp. $x^3(t)$ berechnet werden und dann die FFT-Operation durchgeführt wird:

$$\text{(VII)} \qquad A_n(i) = \frac{1}{2N} \sum_{m=-N}^{N-1} x_m^2(i) f_{mn}, \quad n = -N, \ldots, N-1$$

$$\text{(VIII)} \qquad B_n(i) = \frac{1}{2N} \sum_{m=-N}^{N-1} x_m^3(i) f_{mn}, \quad n = -N, \ldots, N-1$$

Die 2(2N) Hilfsgrössen $\{A_n(i), B_n(i)\}$ werden einerseits zur Berechnung der Koeffizienten $k_1$, $k_2$, $k_3$ und der Durchlaufszeit $t_d$, andererseits für das Vorverzerrungsfilter 3 benötigt.

Das Ausgangssignal y(t) der Verstärkerschaltung 1 wird in gleicher Weise wie x(t) digitalisiert (A/D-Wandler 24) und fouriertransformiert (FFT-Rechner 25).

$$\text{(IX)} \qquad Y_n(i) = \frac{1}{2N} \sum_{m=-N}^{N-1} y_m(i) f_{mn}, \quad n = -N, \ldots, N-1$$

($f_{mn}$ wie in Gleichung (IV)).

($y_m(i)$ bezeichnet das digitalisierte Ausganssignal.) In einem Koeffizientenrechner 26 werden nun aufgrund der Hilfsgrössen $\{A_n(i), B_n(i)\}$ - oder allgemein $\{T[x^\mu(t)], \mu = 2,\ldots,L\}$ - und der Fourierkoeffizienten $Y_n(i)$ die Parameter des Modells, d.h. die Koeffizienten $k_1$, $k_2$, $k_3$ und die Durchlaufszeit $t_d$ geschätzt. Erfindungsgemäss werden dazu die 2N Gleichungen der Form

$$\text{(X)} \qquad Y_n(i) = \alpha^n(i-1) \sum_{\mu=1}^{3} k_\mu(i)\, T[x^\mu(t)], \quad n = -N \ldots N-1,$$

verwendet. Sie gehören zu den 2N Abtastwerten pro Rechenzyklus. Es wird angenommen, dass die komplexe Grösse $\alpha(i-1)$, deren Betragswert 1 ist, aus dem vorhergehenden Rechenzyklus bekannt oder im Sinn einer Vorabschätzung festgelegt worden ist. Damit steht für die 3 Koeffizienten $k_\mu$, $\mu$ = 1...3, ein überbestimmtes Gleichungssystem zur Verfügung, das vorzugsweise nach der an sich bekannten Methode der kleinsten Fehlerquadrate aufgelöst wird. In Matrixschreibweise lautet die Lösung wie folgt:

(XI) $\underline{k}(i) = [M(i)^T M(i)]^{-1} M(i) \underline{Y}(i)$

Die einzelnen Grössen sind wie folgt definiert:

(XII) $\underline{k}(i) = [k_1(i), k_2(i), k_3(i)]^T$

(XIII) $\underline{Y}(iI = [Y_{N-1}(i), ..., Y_{-N}(i)]^T$

(XIV) $$M(i) = \begin{pmatrix} \alpha^N(i-1)X_N(i) & \alpha^N(i-1)A_N(i) & \alpha^N(i-1)B_N(i) \\ \vdots & \vdots & \vdots \\ \alpha^{-N}(i-1)X_{-N}(i) & \alpha^{-N}(i-1)A_{-N}(i) & \alpha^{-N}(i-1)B_{-N}(i) \end{pmatrix}$$

Wenn der Koeffizientenvektor $\underline{k}(i)$ des i-ten Steuerzyklus bestimmt ist, dann kann die Durchlaufszeit $t_d(i)$ ermittelt werden. Diese ist im Argument der komplexen Grösse $\alpha(i)$ enthalten:

(XV) $\alpha(i) = \exp(-j2\pi(t_d(i) - t_{d0})/T_s)$ ($t_{d0}$ = erste Näherung für Durchlaufszeit $t_d$)

Im Prinzip werden wieder die 2N Gleichungen der Formel (X) herangezogen. Die Lösung ist diesmal der Wert $\alpha(i)$, der die Grösse $I[\alpha(i)]$ minimiert:

(XVI) $$I[\alpha(i)] = \sum_{\substack{n=-N \\ n<>0}}^{N-1} [P_n^{1/n}(i) - \alpha(i)]^2$$

(XVII) $P_n(i) = Y_n(i)/[k_1(i)X_n(i) + k_2(i)A_n(i) + k_3(i)B_n(i)]$

Eine Auflösung nach $\alpha(i)$ ergibt:

(XVIII) $$\alpha(i) = \frac{1}{2N-1} \sum_{\substack{n=-N \\ n<>0}}^{N-1} P_n^{1/n}(i)$$

Die Durchlaufszeit $t_d(i)$ lässt sich mit Hilfe der Formel (XV) gewinnen:

(XIX) $t_d(i) = \Theta(i)2NT_s/2\pi$

wobei $\Theta(i)$ das Argument von $\alpha(i)$ ist:

(XX) $\Theta(i) = \arg\{\alpha(i)\}$, resp. $\alpha(i) = \exp[-j\Theta(i)\}$.

Damit sind alle gesuchten Parameter bestimmt und können zur Vorverzerrung verwendet werden.

Es ist anzumerken, dass $t_d$ auch in abgewandelter Weise berechnet werden kann. Die Erfindung beschränkt sich somit nicht auf das soeben beschriebene Verfahren zur Bestimmung der Durchlaufszeit.

Das Verfahren arbeitet rekursiv. Um es in Gang zu setzen, müssen für die zu bestimmenden Koeffizienten $k_\mu$, $\mu$ = 1...L, Anfangswerte vorgegeben werden. Auf diese Werte kommt es aber nicht wirklich an, da die Koeffizienten $k_\mu$, $\mu$ = 1...L, in Regelfall (d.h. bei einigermassen vernünftigen Vorgaben, z.B. $|k1| >> |k\mu|$, $\mu \neq 1$, d.h. $\mu$ = 2, 3, .., L) nach wenigen Durchläufen auf die gesuchten Werte hin konvergieren werden.

Das Identifikationsverfahren umfasst für den bevorzugten Fall L = 3 also folgende Schritte:

1. Mit Hilfe der FFT die Koeffizienten $X_n(i)$, $Y_n(i)$, $A_n(i)$ und $B_n(i)$ (gemäss Formeln (III) und (IX)) für n = -N...N bestimmen.
2. Aus diesen Koeffizienten und den Werten $\alpha(i-1)$ des vorhergehenden Schätzungszyklus die Matrix M gemäss Formel (XIV) bilden.

3. Die Koeffizienten $k_\mu(i)$, $\mu$ = 1...3, aus Gleichung (XI) berechnen.

4. Unter Verwendung der neu bestimmten Koeffizienten $k_\mu(i)$, $\mu$ = 1...3, die komplexe Grösse $\alpha(i)$ und daraus die Durchlaufszeit $t_d(i)$ gemäss Formeln (XVIII) und (XIX) ermitteln.

Im Prinzip können die Koeffizienten $k_\mu$, $\mu$ = 1...L, und/oder die Durchlaufszeit $t_d$ einmal bestimmt werden, z.B. bei der Inbetriebsetzung des Verstärkers, und dann als Konstanten für die Vorverzerrung benutzt werden. Vorzugsweise wird die Verstärkercharakteristik aber ständig von neuem identifiziert, so dass im Endeffekt eine adaptive Kompensation der Nichtlinearität resultiert.

Für den Fachmann ergeben sich aus dem beschriebenen Identifikationsverfahren schaltungstechnisch oder softwaremässig verschieden implementierbare Ausführungsformen. Der hier beschriebene Identifikationsprozessor ist deshalb nur als eine unter mehreren gleichwertigen Möglichkeiten zu verstehen. Entsprechend ist die Erfindung auch nicht in diesem engen Rahmen zu sehen. Beispielsweise kann die Zeitverzögerung des Eingangssignals x(t) im Identifikationsprozessor auch erst auf digitaler Stufe eingeführt werden. Ebenso können die relevanten Formeln auch auf andere Weise (z.B. in mehreren Einzelschritten) ausgewertet werden. Wichtig ist nur, dass im Endeffekt eine Lösung vorliegt, die sich mathematisch gesehen in der explizit gegebenen Weise ausdrücken lässt.

Als nächstes werden einige bevorzugte Ausführungsformen des Vorverzerrungsfilters 3 beschrieben.

Fig. 3 zeigt ein Vorverzerrungsfilter nach dem Feedforward-Prinzip (open loop). Die vom Identifikationsprozessor 2 gelieferten komplexen Grössen $A_n(i)$ und $B_n(i)$ werden in einem Verzögerungsglied 31 um einen Steuerungszyklus verzögert. Dann werden mit einem ersten und einem zweiten Multiplizierer 32 und 33 die zwei Summanden $A_n(i-1)k_2(i)$ und $B_n(i-1)k_3(i)$ gebildet und in einem Summierglied 34 addiert. Die resultierende Summe wird in einem weiteren Multiplizierer 35 mit einem bestimmten Faktor -K gewichtet. Damit liegen die Fourierkoeffizienten $C_n(i)$ des Korrektursignals vor. Ein $FFT^1$-Rechner 36 ermittelt unter Verwendung der schnellen inversen Fouriertransformation das digitale Korrektursignal $c_m(i)$ im Zeitbereich, das schliesslich mit einem D/A-Wandler 37 in ein analoges Signal c(t) übergeführt wird und zum Eingangssignal s(t) hinzuaddiert wird (Summierglied 38).

Das Korrektursignal c(t) ist also aus folgenden Fourierkoeffizienten $C_n$ synthetisiert worden:

$$\text{(XXI)} \qquad C_n(i) = -K\,[k_2(i)A_n(i-1) + k_3(i)B_n(i-1)]$$

$$\text{(XXII)} \qquad c_m(i) = \sum_{n=-N}^{N-1} C_n(i) f_{mn}^{-1} \quad , n = -N, \ldots, N-1$$

($f_{mn}$ wie in Gleichung (IV)).

Der Gewichtungsfaktor -K kann wahlweise aus einer der beiden folgenden Beziehungen ermittelt werden:

$$\text{(XXIII)} \qquad K = \frac{1}{k_1(i)}$$

oder

$$\text{(XXIV)} \qquad K = \frac{1}{k_1(i)} \left[ 1 + \frac{jn\pi T_s/N}{K_c k_1^2(i) \alpha^n(i)} \right]^{-1}$$

$K_c$ bezeichnet eine frei wählbare Konstante (Gain), die sich nicht auf die Vorverzerrung als solche, sondern nur auf deren Konvergenzverhalten auswirkt. Der Gewichtungsfaktor wird in einem Rechenglied 30 ermittelt.

Figuren 4 und 5 zeigen ein Beispiel für ein Vorverzerrungsfilter 4 nach dem Feedback-Prinzip. Verstärkerschaltung 1 und Identifikationsprozessor 2 sind wie im ersten Ausführungsbeispiel geschaltet und ausgebildet. Unterschiedlich ist nur das Vorverzerrungsfilter 4, das nun neben den Koeffizienten $k_\mu$,$\mu$ = 1...L, auch die Durchlaufszeit $t_d$ und das Ausgangssignal y(t) der Verstärkerschaltung 1 verwertet.

Im Vorverzerrungsfilter 4 wird das Eingangssignal s(t) unter anderem auf ein einstellbares Verzögerungsglied 48 geführt, das eine Zeitverzögerung entsprechend der geschätzten Durchlaufszeit $t_d(i)$ einführt. Das verzögerte Eingangssignal wird auf zwei Pfade aufgeteilt. Im einen erzeugt ein Teilsignalgenerator 49 ein Teilsignal $\partial e/\partial c$ von der Form

$$\text{(XXV)} \qquad \partial e/\partial c = \sum_{\mu=1}^{L} \mu k_\mu(i)[s(t - t_d(i))]^{\mu-1},$$

das nachher in einem Multiplizierer 42 mit einem festen Gewichtungsfaktor $-K_c$ multipliziert wird. Im anderen Pfad erfolgt eine Verstärkung mit dem Koeffizienten $k_1(i)$ (Multiplizierer 40). Danach wird unter Verwendung des rückgeführten Ausgangssignals y(t) der Verstärkerschaltung 1 ein Differenzsignal e(t) gemäss

$$\text{(XXVI)} \qquad e(t) = y(t) - k_1(i)s(t-t_d)$$

gebildet (Summierglied 41). Das Differenzsignal e(t) wird mit dem Teilsignal $\partial e/\partial c$ multipliziert (Multiplizierer 43) und dann einerseits im Integrator 45 zeitlich aufintegriert und andererseits mit der ermittelten Durchlaufszeit $t_d$ multipliziert (Multiplizierer 44) gemäss

$$\text{(XXVII)} \qquad c(t) = -K_c \left\{ \int [e(t)\cdot\partial e/\partial c]dt + t_d(i)e(t)\cdot\partial e/\partial c \right\}$$

Das Kompensationssignal c(t) wird zum unverzögerten Eingangssignal s(t) hinzuaddiert (Summierglied 47). Damit steht das gewünschte Eingangssignal x(t) der Verstärkerschaltung zur Verfügung.

Fig. 6 schliesslich zeigt eine digitale Variante des Feedback-Prinzips. Das Eingangssignal s(t) resp. das Ausgangssignal y(t) der Verstärkerschaltung 1 werden jeweils von einem A/D-Wandler 50 resp. 58 abgetastet und digitalisiert. Analog zu Fig. 5 wird das digitale Eingangssignal $s_m(i)$ in einem einstellbaren Verzögerungsglied 52 entsprechend der ermittelten Durchlaufszeit $t_d(i)$ verzögert und mit dem linearen Koeffizienten $k_1(i)$ verstärkt (Multiplizierer 53). Das so aufbereitete Eingangssignal wird vom digitalisierten Ausgangssignal $y_m$ subtrahiert (Summierglied 54). Das resultierende (digitale) Differenzsignal $e_m(i)$ wird in einem FFT-Rechner 55 einer schnellen Fouriertransformation unterworfen:

$$\text{(XXVIII)} \qquad E_n(i) = \frac{1}{2N} \sum_{m=-N}^{N-1} e_m(i) f_{mn} \quad , n = -N, \ldots, N-1$$

Der Fehlersignalgenerator 56 erzeugt das gewünschte Fehlersignal $c_m(i)$:

$$\text{(XXIX)} \qquad c_m(i) = - \sum_{\substack{n=-N \\ n<>0}}^{N-1} \frac{N}{jn\pi T_s} k_c k_1(i) E_n(i) f_{mn}^{-1}$$

Dieses wird auf digitaler Ebene zum Eingangssignal $s_m$ hinzuaddiert (Summierglied 57). Das so vorverzerrte Signal wird mit einem D/A-Wandler 51 zum Eingangssignal x(t) der Verstärkerschaltung 1 gemacht.

Die erfindungsgemässe Identifikation und die Kompensation (Vorverzerrung) können auch für sich allein verwendet werden. D.H. die Vorverzerrung kann durchaus auf der Basis einer andersartigen Identifikation erfolgen, sofern letztere die gewünschten Koeffizienten und Durchlaufszeiten liefert. Dabei ist insbesondere auf die eingangs erwähnte, frühere Anmeldung zu verweisen, die das Verstärkersignal auf der Grundlage einer bestimmten, aber näherungsweise infinitesimal kleinen Durchlaufszeit kompensiert. Aus den für den Fachmann eindeutigen Parallelen (Identifikation - Kompensation) können daher weiter Ausführungsformen

ohne erfinderisches Zutun kombiniert werden.

Abschliessend kann festgestellt werden, dass die Erfindung die Linearisierung von nichtlinearen Kennlinien ermöglicht, wie sie insbesondere bei Hochleistungsverstärkern in der Nachrichtentechnik benötigt werden.

## Patentansprüche

1. Verfahren zur Kompensation von Nichtlinearitäten einer Verstärkerschaltung (1) mit ausgeprägter Signaldurchlaufszeit, bei welchem ein Eingangssignal s(t) unter Verwendung einer vorgegebenen, mit Nichtlinearitäten behafteten Verstärkerschaltung (1) zu einem Ausgangssignal y(t) verstärkt wird, dadurch gekennzeichnet, dass
   a) eine vorgegebene Zahl L von Koeffizienten $k_1, \ldots, k_L$ sowie eine Durchlaufszeit $t_d$ der Verstärkerschaltung (1) entsprechend dem Modell

$$u(t) \equiv \hat{y}(t) = \sum_{\mu=1}^{L} k_\mu x^\mu (t-t_d)$$

   bestimmt werden, so dass bei einem gegebenen Eingangssignal x(t) der Verstärkerschaltung (1) das gemäss dem Modell ermittelte Ausgangssignal u(t) mit dem tatsächlichen Ausgangssignal y(t) der Verstärkerschaltung (1) im wesentlichen übereinstimmt,
   b) in einem Vorverzerrungsfilter (4) das Eingangssignal s(t) unter Verwendung des tatsächlichen Ausgangssignals y(t) und der Koeffizienten $k_1, \ldots, k_L$ sowie der Durchlaufszeit $t_d$ der Verstärkerschaltung (1) im Sinn einer Feedback-Steuerung zum Eingangssignal x(t) vorverzerrt wird, und
   c) das vorverzerrte Eingangssignal x(t) der mit Nichtlinearitäten behafteten Verstärkerschaltung (1) zugeführt wird.

2. Verfahren nach Anspruch 1, dadurch gekennzeichnet, dass im Vorverzerrungsfilter (4)
   a) das Eingangssignal s(t) entsprechend der bestimmten Durchlaufszeit $t_d$ verzögert wird,
   b) das verzögerte Eingangssignal $s(t-t_d)$ mit dem entsprechend dem Modell ermittelten linearen Koeffizienten $k_1(i)$ multipliziert wird, um y*(t) zu bilden,
   c) aus dem verzögerten und multiplizierten Eingangssignal y*(t) und dem Ausgangssignal y(t) der Verstärkerschaltung (1) ein Differenzsignal e(t) gebildet wird,
   d) das Differenzsignal mit einem Teilsignal e/ c der Form

$$\partial e/\partial c = \sum_{\mu=1}^{L} \mu k_\mu(i)[s(t - t_d(i))]^{\mu-1}$$

   multipliziert wird,
   e) ein Kompensationssignal c(t) gemäss

$$c(t) = -K_c \left\{ \int [e(t)\cdot\partial e/\partial c]dt + t_d(i)e(t)\cdot\partial e/\partial c \right\}$$

   gebildet wird und
   f) als vorverzerrtes Eingangssignal x(t) der Verstärkerschaltung (1) das Summensignal aus Kompensationssignal c(t) und Eingangssignal s(t) verwendet wird:

   x(t) = s(t) + c(t) .

3. Verfahren zur Kompensation von Nichtlinearitäten einer Verstärkerschaltung (1) mit ausgeprägter Signaldurchlaufszeit, bei welchem ein Eingangssignal s(t) unter Verwendung einer vorgegebenen, mit Nichtlinearitäten behafteten Verstärkerschaltung (1) zu einem Ausgangssignal y(t) verstärkt wird,

dadurch gekennzeichnet, dass

a) eine vorgegebene Zahl L von Koeffizienten $k_1$, ..., $k_L$ sowie eine Durchlaufszeit $t_d$ der Verstärkerschaltung (1) entsprechend dem Modell

$$u(t) = \sum_{\mu=1}^{L} k_\mu x^\mu(t-t_d)$$

bestimmt werden, so dass bei einem gegebenen Eingangssignal x(t) der Verstärkerschaltung (1) das gemäss dem Modell ermittelte Ausgangssignal u(t) mit dem tatsächlichen Ausgangssignal y(t) der Verstärkerschaltung (1) im wesentlichen übereinstimmt,

b) in einem Vorverzerrungsfilter (3) im Sinn einer offenen Feedforward-Steuerung allein unter Verwendung des gegebenen Eingangssignals x(t) sowie der Koeffizienten $k_1$, ..., $k_L$ und der Durchlaufszeit $t_d$ der Verstärkerschaltung (1) ein zum Einganssignal s(t) additives Kompensationssignal c(t) gebildet wird, und

c) das Eingangssignal x(t) der mit Nichtlinearitäten behafteten Verstärkerschaltung (1) aus der Summe aus dem Eingangssignal s(t) und dem Kompensationssignal c(t) gebildet wird.

**4.** Verfahren nach Anspruch 3, dadurch gekennzeichnet, dass die Fourierkoeffizienten $C_n(i)$ des additiven Kompensationssignals c(t) gemäss der Beziehung

$$C_n(i) = K \sum_{\mu=2}^{L} k_\mu(i)\ T[x^\mu(t)]\ ,\ n = -N...N+1\ ,$$

ermittelt werden, wobei wahlweise

$K = -1/k_1(i)$

oder

$K = K_c k_1(i)\alpha^n(i)\ [jn\pi T_s/N + K_c k_1{}^2(i)\alpha^n(i)]^{-1}$

$K_c$ = geeignet vorgegebene Konstante,

und das Kompensationssignal c(t) unter Verwendung der schnellen Fouriertransformation aus den Fourierkoeffizienten $C_n(i)$ erzeugt wird.

**5.** Verfahren zum Bestimmen von Nichtlinearitäten einer Verstärkerschaltung (1) insbesondere für die Verwendung bei einem Verfahren gemäss einem der Ansprüche 1 bis 4, dadurch gekennzeichnet, dass in einem Identifikationsprozessor (2)

a) Eingangssignal x(t) und Ausgangssignal y(t) der Verstärkerschaltung (1) mit einer Abtastrate $1/T_s$ abgetastet und einer schnellen Fouriertransformation unterworfen werden,

b) eine vorgegebene Zahl L von Koeffizienten $k_1$, ..., $k_L$ bei einer bestimmten Durchlaufszeit $t_d(i-1)$ der Verstärkerschaltung (1) entsprechend dem Modell

$$u(t) = \sum_{\mu=1}^{L} k_\mu x^\mu(t-t_d)$$

geschätzt werden, indem mit den 2N Gleichungen der Form

$$Y_n(i) = \alpha^n(i-1) \sum_{\mu=1}^{L} k_\mu{}^\mu(i)\ T[x^\mu(t)]\ ,\ n = -N...N-1\ ,$$

wobei

$Y_n(i)$ = Fourierkoeffizient des Ausgangssignals y(t)
$\alpha(i-1)$ = $\exp(-j2\pi(t_d(i-1) - t_{d0})/T_s)$
$t_{d0}$ = erste Näherung für Durchlaufszeit $t_d$
T[.] = FFT-Operator mit Frequenzbegrenzung bei $N2\pi/T_s$,

die zu einem Steuerungsintervall (i) der Länge $2NT_s$ gehören, die Koeffizienten $k_\mu(i)$, $\mu$ = 1...L, gemäss der Methode der kleinsten Fehlerquadrate bestimmt werden, so dass bei einem gegebenen Eingangssignal x(t) der Verstärkerschaltung (1) das gemäss dem Modell ermittelte Ausgangssignal u(t) mit dem tatsächlichen Ausgangssignal y(t) der Verstärkerschaltung (1) im wesentlichen übereinstimmt.

**6.** Verfahren nach Anspruch 5, dadurch gekennzeichnet, dass zur adaptiven Bestimmung der Durchlaufszeit $t_d(i)$ die 2N Gleichungen

$$Y_n(i) = \alpha^n(i) \sum_{\mu=1}^{L} k_\mu{}^\mu(i)\ T[x^\mu(t)]\ ,\ n = -N...N-1\ ,$$

wobei

$t_d(i) = \arg\{\alpha(i)\}\ NT_s/\pi$

eines Steuerintervalls (i) unter Verwendung der ermittelten Koeffizienten $k_1(i)$, ..., $k_L(i)$ nach der Methode der kleinsten Fehlerquadrate bestimmt wird.

**7.** Verfahren nach Anspruch 5 oder 6, dadurch gekennzeichnet, dass das unmittelbare Eingangssignal x(t) der nichtlinearen Verstärkerschaltung (1) im Identifikationsprozessor (2) entsprechend der ersten Näherung $t_{d0}$ der Durchlaufszeit gegenüber dem Ausgangssignal y(t) verzögert wird.

**8.** Verfahren nach einem der Ansprüche 1 bis 7, dadurch gekennzeichnet, dass in jedem Steuerintervall (i) der Länge $2NT_s$ die Koeffizienten $k_1(i)$, ..., $k_L(i)$ und die Durchlaufszeit $t_d(i)$ ständig neu bestimmt werden, so dass eine adaptive Kompensation der Nichtlinearitäten resultiert.

**9.** Verfahren nach einem der Ansprüche 1 bis 8, dadurch gekennzeichnet, dass genau 3 Koeffizienten $k_1$, ..., $k_3$ bestimmt werden.

**10.** Anordnung zum Durchführen des Verfahrens nach Anspruch 5, die eine mit Nichtlinearitäten und einer ausgeprägten Durchlaufszeit behaftete Verstärkerschaltung (1) umfasst, dadurch gekennzeichnet, dass

a) ein Identifikationsprozessor (2) zum Bestimmen der Parameter der Verstärkerschaltung (1) insbesondere nach einem der Ansprüche 5 bis 9 und

b) ein Vorverzerrungsfilter (3, 4, 5) zum Erzeugen eines vorverzerrten Eingangssignal x(t) der Verstärkerschaltung (1) aus einem Eingangssignal s(t) insbesondere nach einem der Ansprüche 1 bis 4 vorgesehen sind.

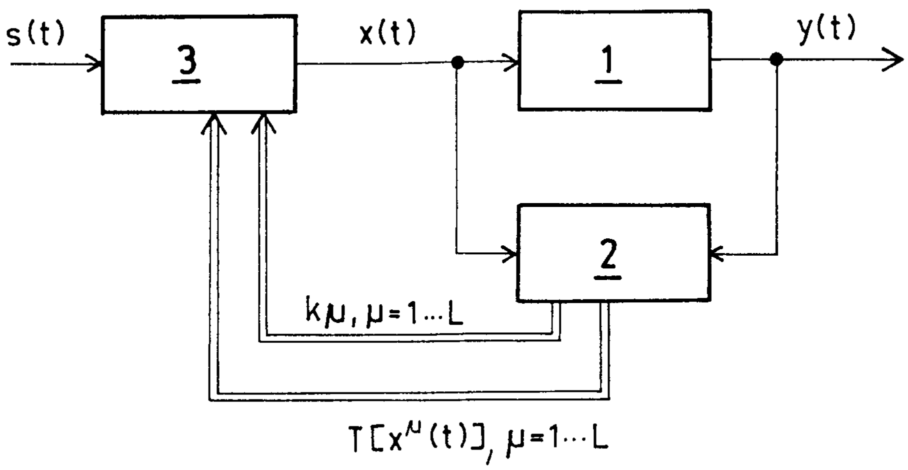
s(t)
3
x(t)
1
y(t)
2
kμ, μ=1...L
T[x^μ(t)], μ=1...L

FIG.1

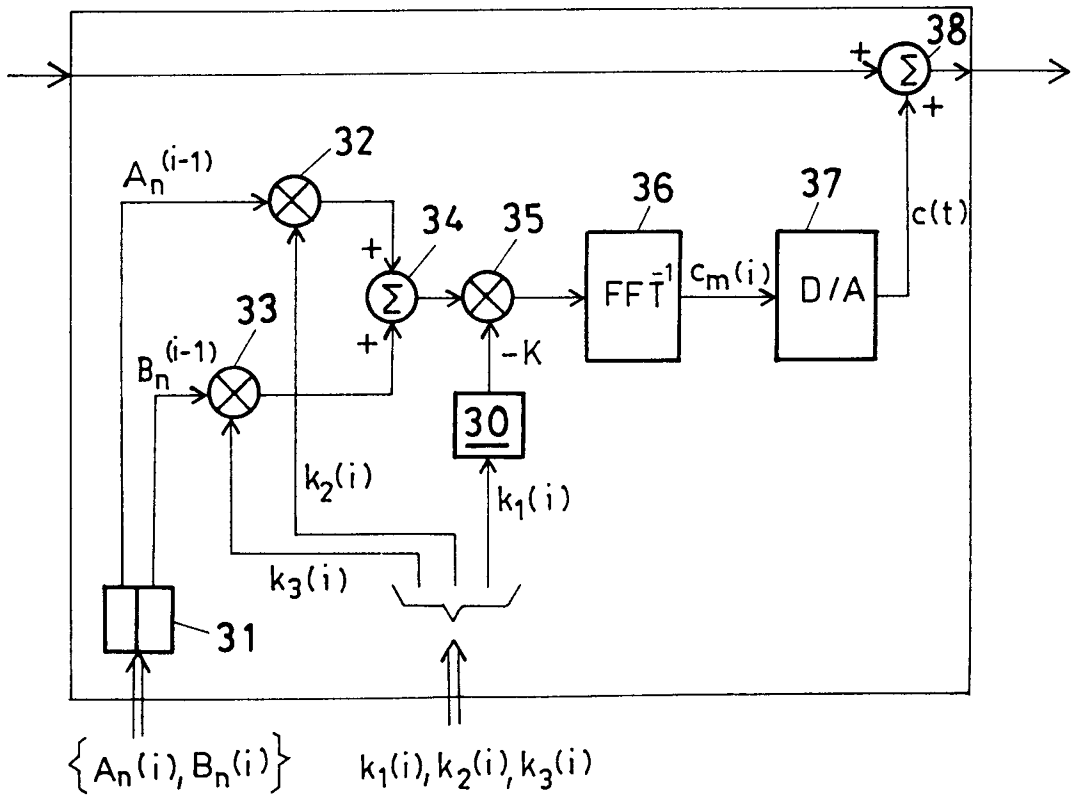
38
+
Σ
+
32
A_n^(i-1)
34
35
36
37
c(t)
+
Σ
+
FFT^-1
c_m(i)
D/A
33
B_n^(i-1)
-K
30
k_2(i)
k_1(i)
k_3(i)
31
{A_n(i), B_n(i)}
k_1(i), k_2(i), k_3(i)

FIG.3

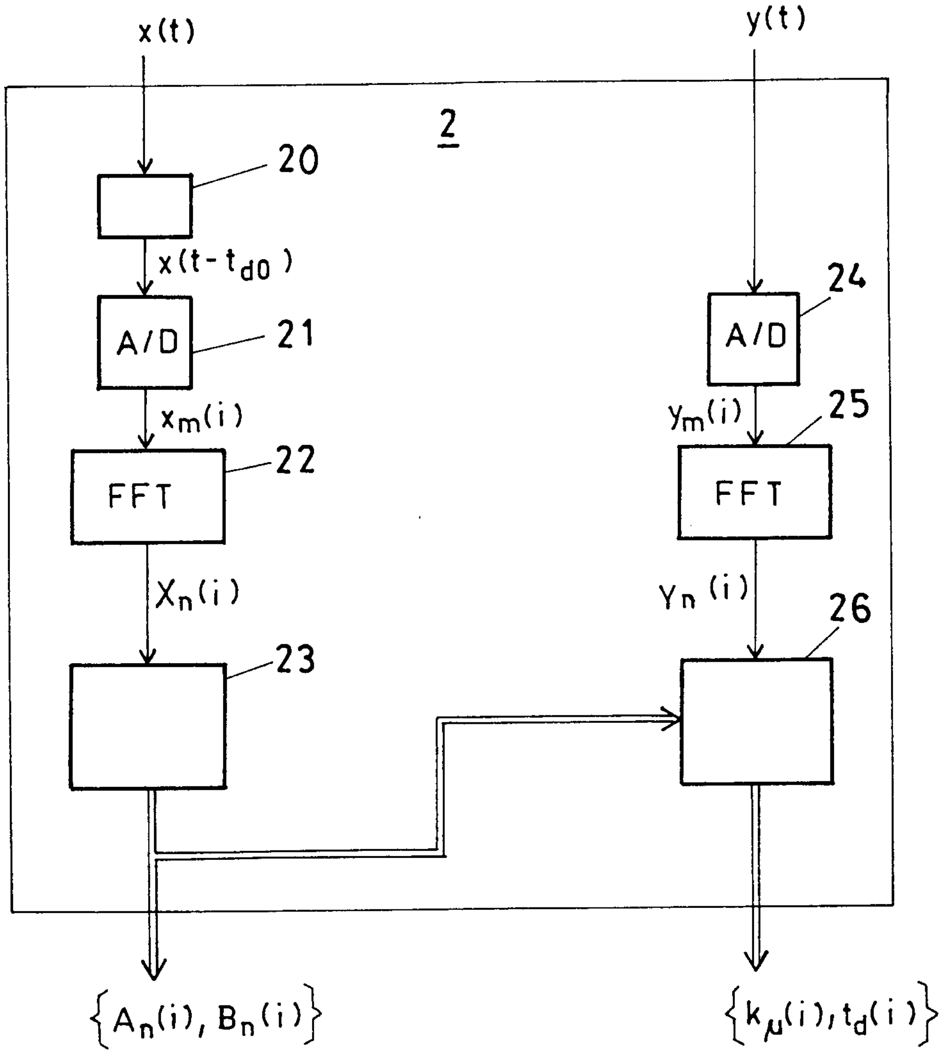

x(t)
y(t)
2
20
x(t-t_{d0})
A/D
21
A/D
24
x_m(i)
y_m(i)
25
FFT
22
FFT
X_n(i)
Y_n(i)
26
23
{A_n(i), B_n(i)}
{k_μ(i), t_d(i)}


FIG.2

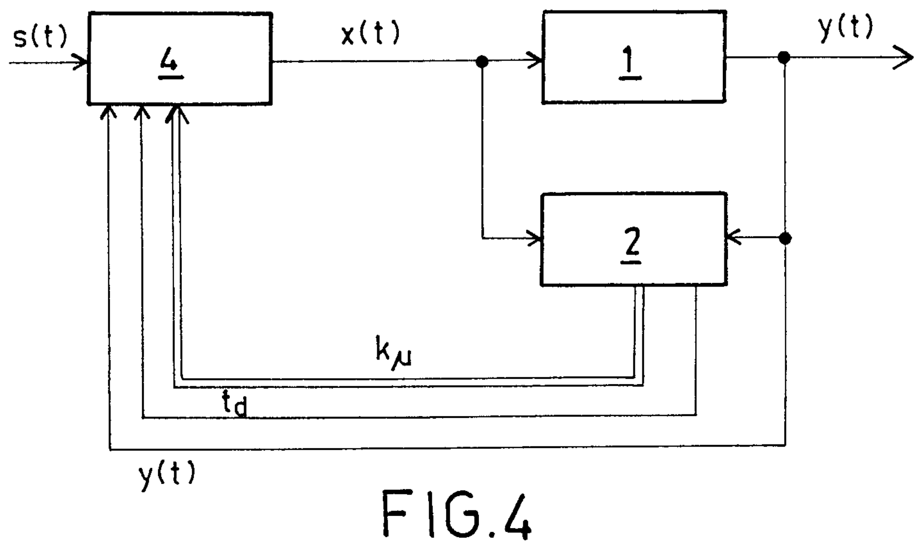
s(t)
4
x(t)
1
y(t)
2
kμ
td
y(t)

FIG.4

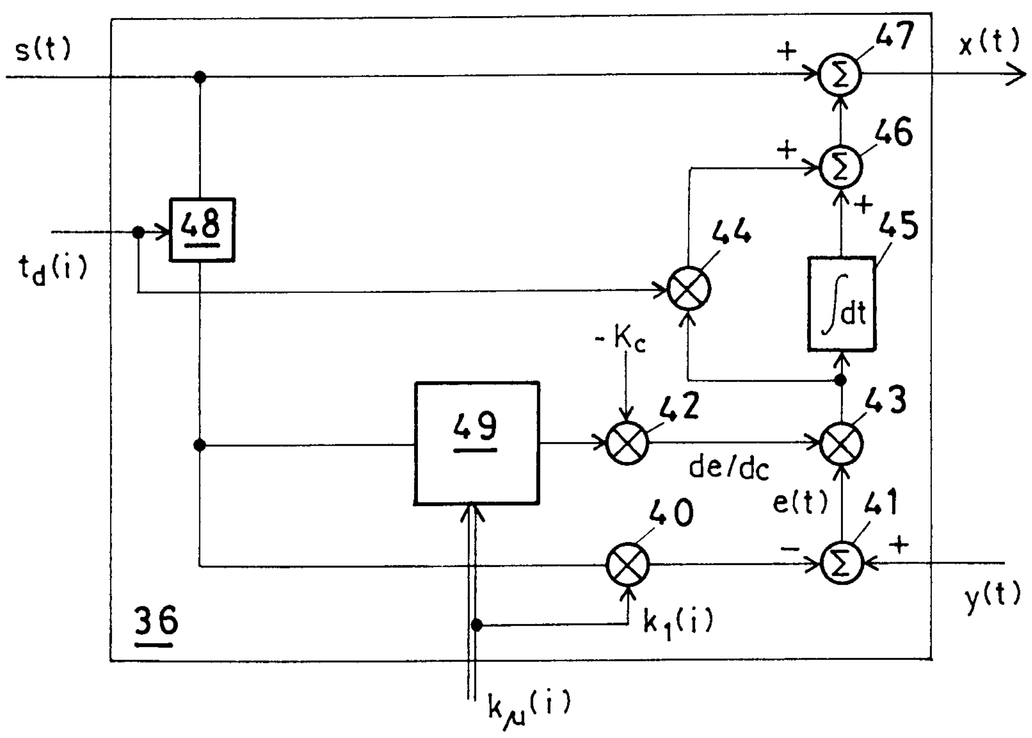
s(t)
+
47
x(t)
46
+
+
45
48
td(i)
44
∫dt
-Kc
42
43
49
de/dc
40
e(t)
41
−
+
y(t)
36
k1(i)
kμ(i)

FIG.5

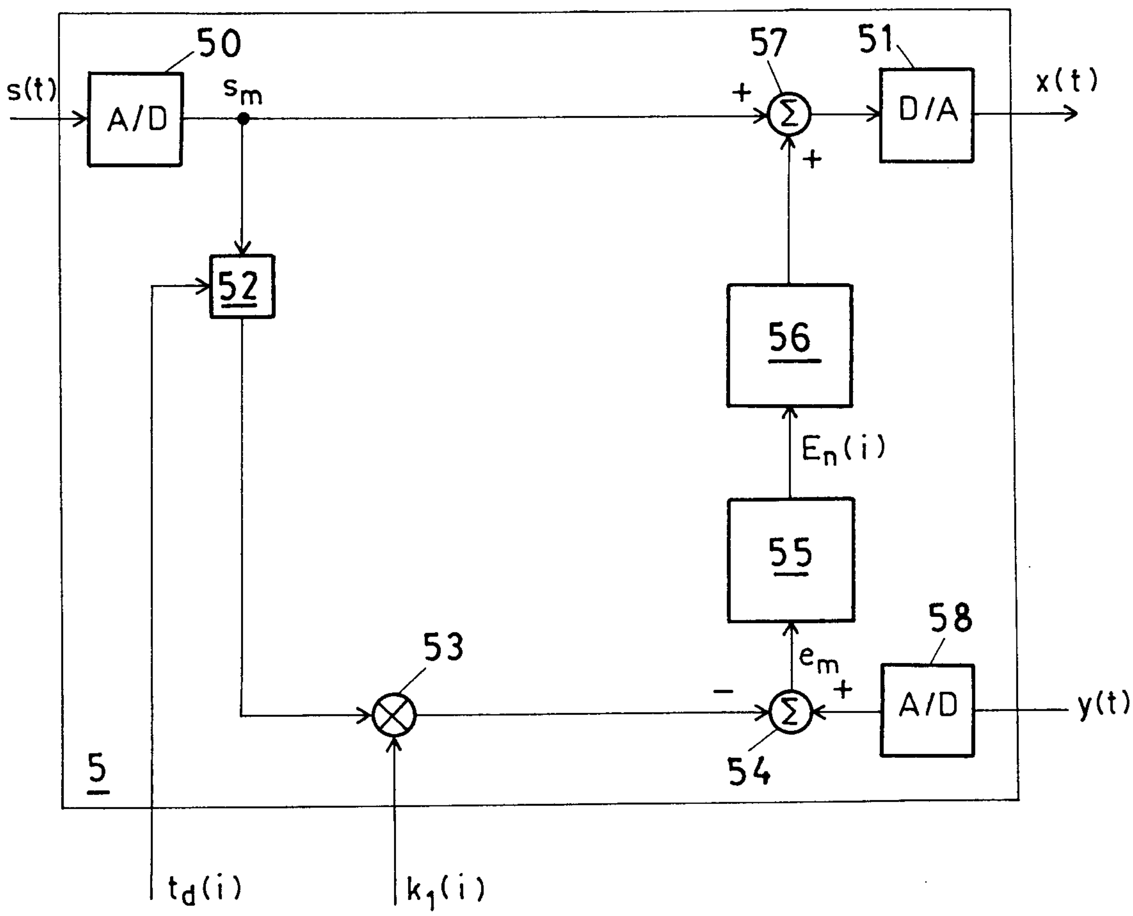


FIG.6

Europäisches Patentamt

# EUROPÄISCHER RECHERCHENBERICHT

Nummer der Anmeldung

EP 91 10 6653

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | PROCEEDINGS OF THE IEEE. Bd. 76, Nr. 10, Oktober 1988, NEW YORK US Seiten 1383 - 1385; J.C. LEE S.K. MITRA: 'On The Block Least Squares Adaptive Digital Filters Realized Using the Fast Fourier Transform' * das ganze Dokument * --- | 1-10 | H03F1/32<br>H03H21/00 |
| A | IEEE INTERNATIONAL CONFERENCE ON COMMUNICATIONS BOSTONICC/89 WORLD PROSPERITY THROUGH COMMUNICATIONS SHERATON BOSTON HOTEL Bd. 3, 11. Juni 1989, BOSTON,MA Seiten 1468 - 1472; R.BLUM ET AL: 'Modeling Nonlinear Amplifiers for Communication Simulation' * das ganze Dokument * --- | 1-10 | |
| A | IEEE INTERNATIONAL CONFERENCE ON COMMUNICATIONS BOSTONICC/89 WORLD PROSPERITY THROUGH COMMUNICATIONS SHERATON BOSTON HOTEL Bd. 1, 11. Juni 1989, BOSTON,MA Seiten 286 - 291; G. KARAM ET AL: 'Improved Data Predistortion Using Intersymbol Interpolation' * Seite 287, linke Spalte, Zeile 43 - Seite 290, linke Spalte, Zeile 6; Abbildung 2 * --- | 1-10 | **RECHERCHIERTE SACHGEBIETE (Int. Cl.5 )**<br>H03F<br>H03H |
| A | PATENT ABSTRACTS OF JAPAN vol. 12, no. 499 (P-807)27. Dezember 1988 & JP-A-63 208 913 ( SHINKEN K.K. ) 30. August 1988 * Zusammenfassung * ----- | 1-10 | |

Der vorliegende Recherchenbericht wurde für alle Patentansprüche erstellt

| Recherchenort | Abschlußdatum der Recherche | Prüfer |
|---|---|---|
| DEN HAAG | 16 DEZEMBER 1991 | TYBERGHIEN G.M. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)